# EUROPEAN PATENT APPLICATION

(11) **EP 2 808 663 A1**
(43) Date of publication of application: **03.12.2014**
(21) Application number: 12866729.2
(22) Date of filing: 24.09.2012
(51) Int. Cl.: G01K 15/00, B60K 6/48, B60L 3/00, B60L 11/14, B60W 10/00, B60W 20/00

(54) **ABNORMALITY DETECTION APPARATUS, HYBRID VEHICLE, ABNORMALITY DETECTION METHOD, AND PROGRAM**

(30) Priority: 27.01.2012 JP 2012015833
(71) Applicant: Hino Motors Ltd., Tokyo 191-8660 (JP)
(72) Inventor: SAKASHITA, Hiroki, Tokyo 1918660 (JP); FUKUDA, Yoshichika, Tokyo 1918660 (JP); YONEMITSU, Tomotaka, Tokyo 1918660 (JP)
(74) Representative: Skone James, Robert Edmund
(86) International application number: PCT/JP2012/074379
(87) International publication number: WO 2013/111380

(57) **Abstract**

Provided are an abnormality detection apparatus that can appropriately detect temperature sensor abnormality, a hybrid vehicle, an abnormality detection method, and a program. A hybrid ECU (18; abnormality detection apparatus) includes: a heat amount calculation means that calculates the amount of heat generated in a predetermined time by a main circuit element of an inverter (14) as an object of temperature detection by a temperature sensor (19); a temperature change calculation means that calculates the amount of change in temperature of the main circuit element of the inverter (14) in the predetermined time; a coordinate value calculation means that calculates coordinate values in a coordinate system in which information about the amount of heat calculated by the heat amount calculation means is expressed by one coordinate axis and in which information about the amount of change in temperature of the temperature sensor (19) that is calculated by the temperature change calculation means is expressed by another coordinate axis; and an abnormality detection means that detects abnormality in the temperature sensor (19) when the coordinate values calculated by the coordinate value calculation means are contained in a predetermined abnormality detection determination area in the coordinate system continuously for a certain time.

## Description

### {Technical Field}

The present invention relates to an abnormality detection apparatus, a hybrid vehicle, and an abnormality detection method, and a program.

### {Background Art}

A temperature sensing device, such as a thermistor, is used for sensing a temperature of an element configuring a circuit for an electric motor or an inverter in a hybrid vehicle. As a technology for detecting an abnormality of such a temperature sensing means itself, it is known, for example, to judge whether a value corresponding to an estimated temperature at a section heated by an electric current has changed more than a predetermined value, and to judge the temperature sensing means itself being abnormal if a sensed temperature, in the case of the temperature having changed more than the predetermined value, does not change more than a predetermined temperature range (refer to PTL 1).

### {Citation List}

### {Patent Literature}

{PTL1} JP 3409756 B

### {Summary of Invention}

### {Technical Problem}

As a method of detecting abnormality of a temperature sensing means itself, it may be conceived that two temperature sensing devises are provided in order to detect abnormality of the temperature sensing means by way of referring to and watching values sensed out of these two temperature sensing devices. Unfortunately, it leads to a higher cost since two temperature sensing devices are provided.

Meanwhile, in a method disclosed in PTL 1, a temperature condition is specified with respect to a range for judging abnormality of a temperature sensing means. This is because a thermistor to be commonly used as a temperature sensing device has an output performance that is non-linear in regard to a change in temperature. Therefore, the thermistor is designed and tuned in such a way that an output performance in a temperature range, where abnormality must be judged accurately, becomes as linear as possible. Accordingly, outside the predetermined temperature range of condition, which is a range for judging abnormality, the thermistor has a less output change in regard to an actual change in temperature so that there is a threat of making a misjudgment. In other words, since there exists a chance that the method disclosed in PTL 1 may make a misjudgment under condition lower than the predetermined temperature range, abnormality of the thermistor cannot appropriately be detected.

The present invention is materialized against such a background, and thus it is an objective of the present invention to provide an abnormality detection apparatus, a hybrid vehicle, and an abnormality detection method, and a program, with which abnormality of a temperature sensor can appropriately be detected.

### {Solution to Problem}

An aspect of the present invention is with respect to abnormality detection apparatus. The abnormality detection apparatus for detecting abnormality of a temperature sensor according to the present invention comprises: a heat amount calculation means which calculates the amount of heat generated in a predetermined time period from an object of sensing temperature by the temperature sensor; a temperature change calculation means which calculates the amount of temperature change of the object of sensing temperature in the predetermined time period; a coordinate value calculation means which calculates a coordinate value in a coordinate system represented by having the heat amount information calculated by the heat amount calculation means, on a coordinate axis, and having information on the amount of temperature change of the temperature sensor, calculated by the temperature change calculation means, on another coordinate axis; and an abnormality detection means which detects abnormality of the temperature sensor in the case where the coordinate value calculated by the coordinate value calculation means is included in a predetermined abnormality detection judgment area in the coordinate system continuously for a certain time.

Furthermore, the predetermined abnormality detection judgment area is a coordinate area not included in a normal operation pattern area formed with a plurality of coordinate values obtained on the basis of relationships between an hour integration value calculated by use of a current value and an energization time of the object of sensing temperature in a predetermined time period, and the amount of temperature change of the object of sensing temperature in the predetermined time period, under conditions where the temperature sensor works normally; in the case where the coordinate value calculated by the coordinate value calculation means is continuously included for a certain time in a first abnormal temperature-change area, in which the amount of temperature change calculated by the temperature change calculation means is greater, in comparison with the coordinate values included in the normal operation pattern area, or in the case where the coordinate value calculated by the coordinate value calculation means is continuously included for a certain time in a second abnormal temperature-change area, in which the amount of temperature change calculated by the temperature change calculation means is smaller, in comparison with the coordinate values included in the normal operation pattern area; under either of the conditions described above, preferably the abnormality detection means detects abnormality of the temperature sensor.

Another aspect of the present invention is with respect to a hybrid vehicle. The hybrid vehicle according to the present invention comprises: a temperature sensor, a heat amount calculation means which calculates the amount of heat generated in a predetermined time period from an object of sensing temperature by the temperature sensor; a temperature change calculation means which calculates the amount of temperature change of the object of sensing temperature in the predetermined time period; a coordinate value calculation means which calculates a coordinate value in a coordinate system represented by having the heat amount information calculated by the heat amount calculation means, on a coordinate axis, and having information on the amount of temperature change of the temperature sensor, calculated by the temperature change calculation means, on another coordinate axis; and an abnormality detection means which detects abnormality of the temperature sensor in the case where the coordinate value calculated by the coordinate value calculation means is included in a predetermined abnormality detection judgment area in the coordinate system continuously for a certain time.

Another aspect of the present invention is with respect to an abnormality detection method. The abnormality detection method for detecting abnormality of a temperature sensor according to the present invention comprises: a heat amount calculation step for calculating the amount of heat generated in a predetermined time period from an object of sensing temperature by the temperature sensor; a temperature change calculation step for calculating the amount of temperature change of the object of sensing temperature in the predetermined time period; a coordinate value calculation step for calculating a coordinate value in a coordinate system represented by having the heat amount information calculated by the heat amount calculation step, on a coordinate axis, and having information on the amount of temperature change of the temperature sensor, calculated by the temperature change calculation step, on another coordinate axis; and an abnormality detection step for detecting abnormality of the temperature sensor in the case where the coordinate value calculated by the coordinate value calculation step is included in a predetermined abnormality detection judgment area in the coordinate system continuously for a certain time.

Another aspect of the present invention is with respect to a computer program. The computer program according to the present invention causes a computer to function for detecting abnormality of a temperature sensor as: a heat amount calculation means which calculates the amount of heat generated in a predetermined time period from an object of sensing temperature by the temperature sensor; a temperature change calculation means which calculates the amount of temperature change of the object of sensing temperature in the predetermined time period; a coordinate value calculation means which calculates a coordinate value in a coordinate system represented by having the heat amount information calculated by the heat amount calculation means, on a coordinate axis, and having information on the amount of temperature change of the temperature sensor, calculated by the temperature change calculation means, on another coordinate axis; and an abnormality detection means which detects abnormality of the temperature sensor in the case where the coordinate value calculated by the coordinate value calculation means is included in a predetermined abnormality detection judgment area in the coordinate system continuously for a certain time.

### {Advantageous Effects of Invention}

According to the present invention, it becomes possible to provide an abnormality detection apparatus, a hybrid vehicle, and an abnormality detection method, and a program, with which abnormality of a temperature sensor can appropriately be detected.

### {Brief Description of Drawings}

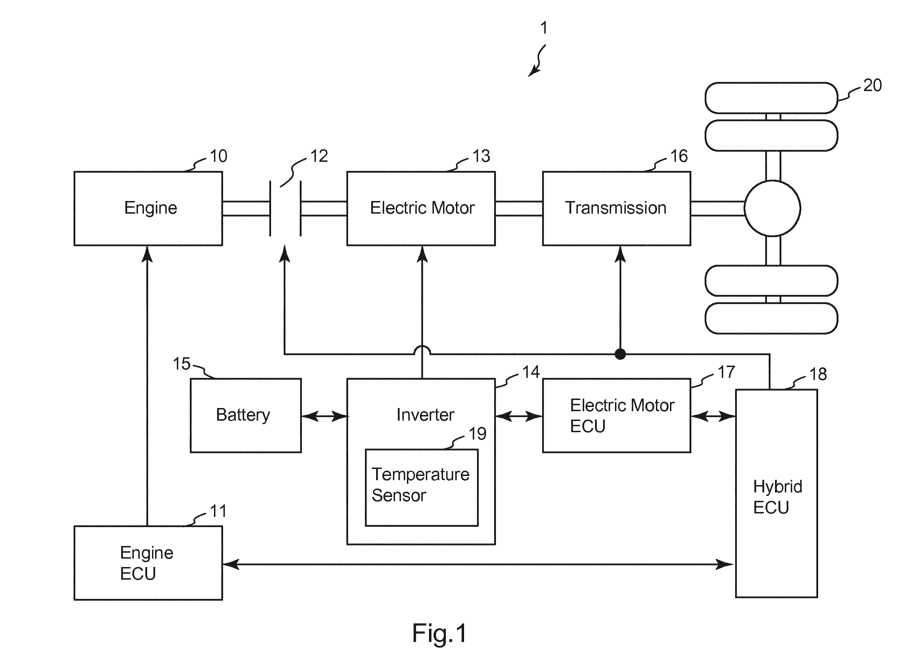

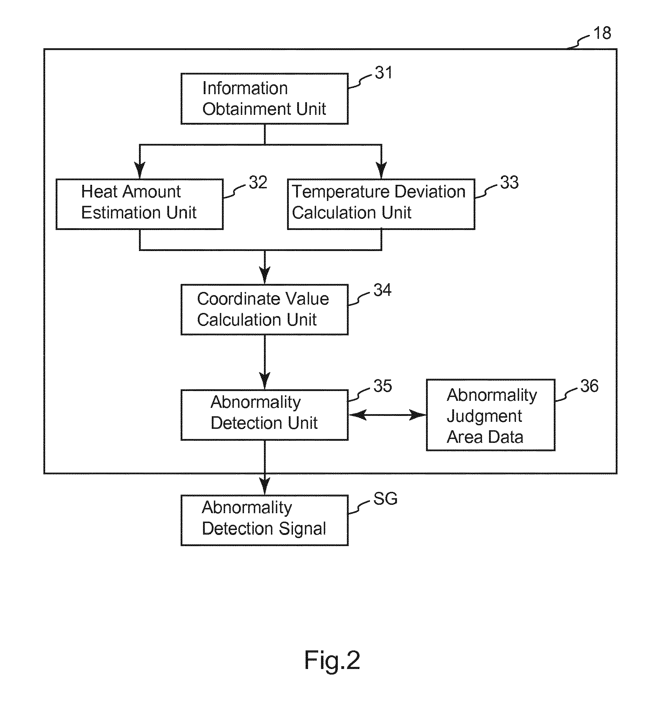

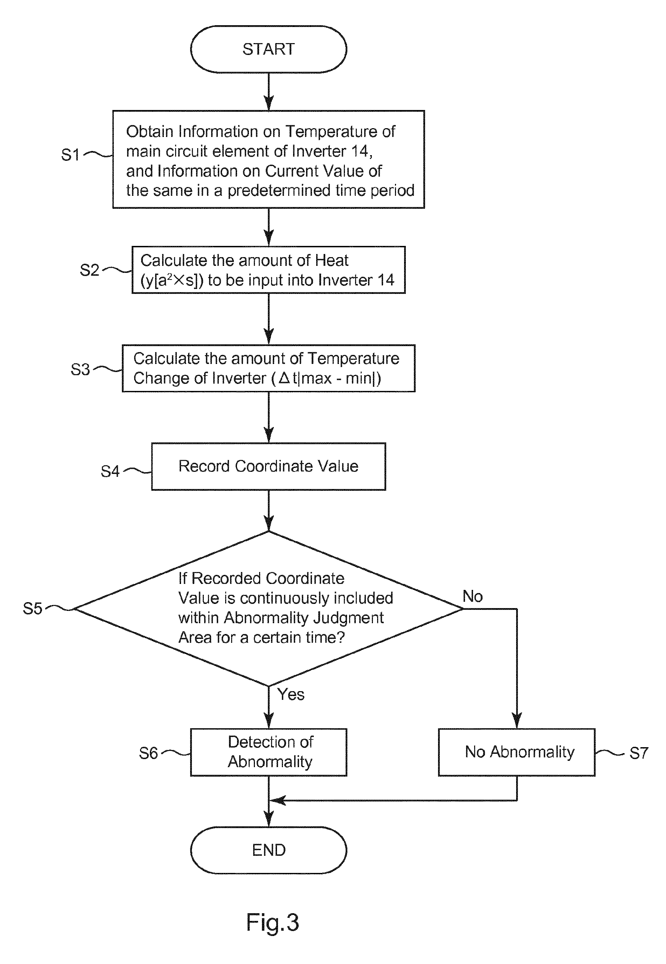

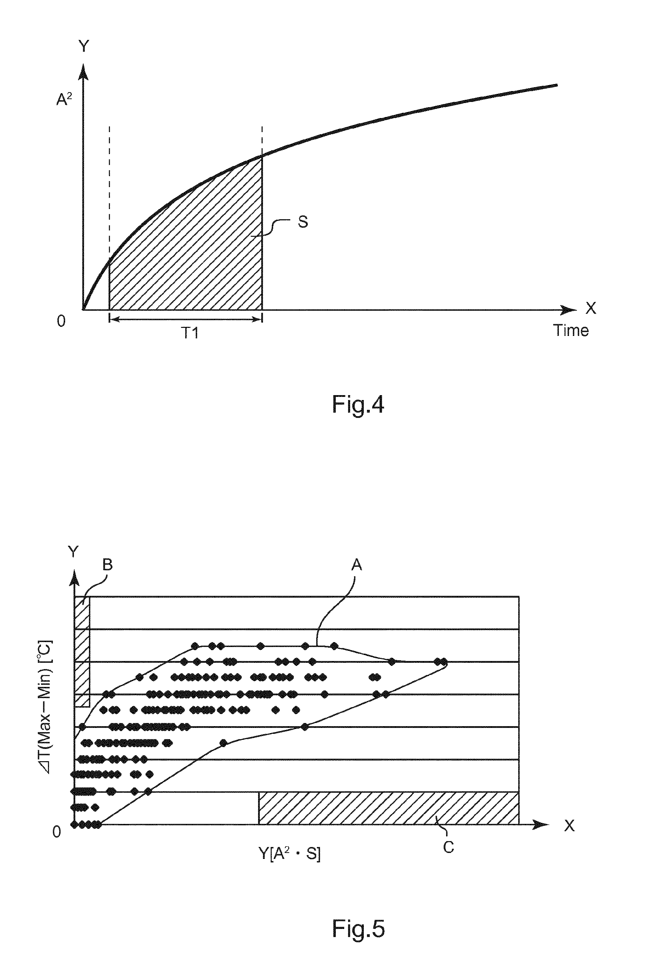

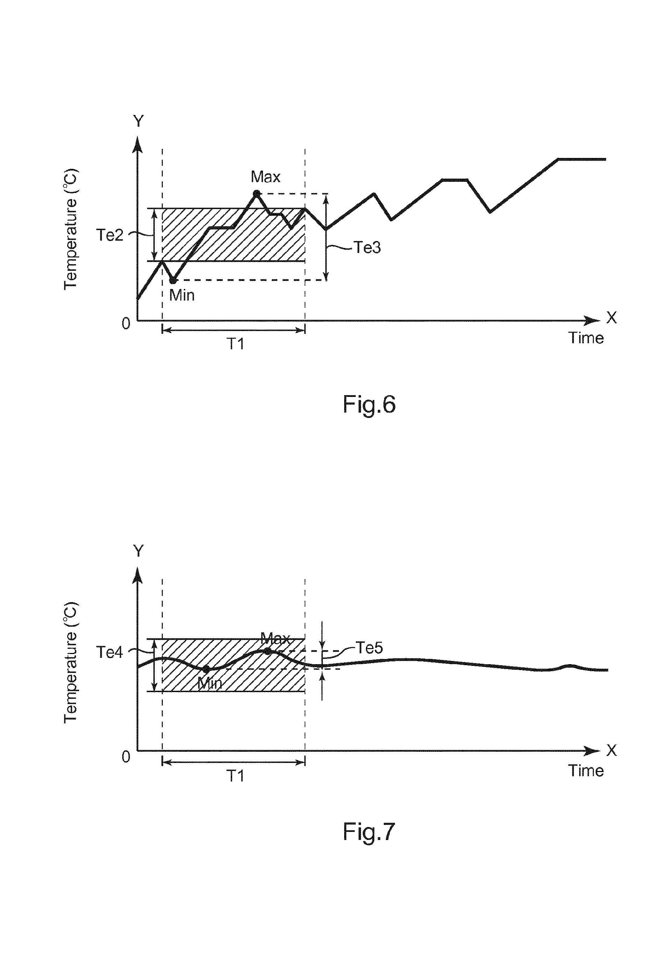

{Fig. 1} FIG. 1 is a configuration block diagram of substantial sections of a hybrid vehicle according to an embodiment of the present invention.
{Fig. 2} FIG. 2 is a block diagram showing an example of functional configuration of a hybrid ECU represented in FIG. 1, for implementation of an abnormality detection process.
{Fig. 3} FIG. 3 is a flowchart showing an abnormality detection process on a temperature sensor, which is executed by the hybrid ECU represented in FIG. 1.
{Fig. 4} FIG. 4 is an example of a diagram in which an X-axis represents time (T) of energizing a main circuit element of an inverter shown in FIG. 1, and meanwhile a Y-axis represents the square of a current value of a current (A2), the current flowing into the main circuit element of the inverter.
{Fig. 5} FIG. 5 is an example of a diagram represented by way of having an X-axis with hour integration value information (Y{A2×S}) and a Y-axis with temperature deviation information (ΔT|Max - Min|).
{Fig. 6} FIG. 6 is a diagram that shows an example of a change in temperature included in an abnormality judgment area 'B' shown in FIG. 5.
{Fig. 7} FIG. 7 is a diagram that shows an example of a change in temperature included in an abnormality judgment area 'C' shown in FIG. 5.

### {Description of Embodiments}

With reference to the drawings, an explanation is made below with respect to an embodiment according to the present invention. Nevertheless, an abnormality detection apparatus, a hybrid vehicle, and an abnormality detection method, and a program of the present invention are not limited to a configuration shown in the drawings.

### [Configuration]

FIG. 1 is a configuration block diagram of substantial sections of a hybrid vehicle 1 according to an embodiment of the present invention. As shown in FIG. 1, the hybrid vehicle 1 comprises; an engine 10, an engine ECU (Electronic Control Unit) 11, a clutch 12, an electric motor 13, an inverter 14, a battery 15, a transmission 16, an electric motor ECU 17, a hybrid ECU 18, a temperature sensor 19, and a wheel 20. Incidentally, an illustration of a configuration that is not directly related to an explanation is omitted in the configuration of FIG. 1.

### [Outline]

The hybrid vehicle 1 has the temperature sensor 19 for sensing a temperature change of the inverter 14, and the hybrid ECU 18 detects abnormality of the temperature sensor 19 itself.

The engine 10 is an example of an internal combustion engine, and the engine 10 is controlled by the engine ECU 11. The engine 10 combusts gasoline, diesel oil, CNG (Compressed Natural Gas), LPG (Liquefied Petroleum Gas), or alternative fuel and the like inside the engine 10 in order to generate power for rotating a shaft, and then transmits the generated power to the clutch 12.

The engine ECU 11 is a computer that cooperates with the electric motor ECU 17, by way of following an instruction coming from the hybrid ECU 18. The engine ECU 11 controls operation of the engine 10, for example, an amount of fuel consumption, timing of valve operation, and the like. The engine ECU 11 is structured with, for example, a CPU (Central Processing Unit), an ASIC (Application Specific Integrated Circuit), a micro-processor, or a DSP (Digital Signal Processor); and it internally includes an arithmetic section, a memory, an I/O (input/output) port, and so on.

The clutch 12 is controlled by the hybrid ECU 18. The clutch 12 transmits a shaft output from the engine 10 to the wheel 20, by the intermediary of the electric motor 13 and the transmission 16. In other words, the clutch 12 transmits a shaft output of the engine 10 to the electric motor 13, by way of mechanically connecting a driving shaft of the engine 10 and a driving shaft of the electric motor 13. Moreover, by way of disconnecting the mechanical connection between the driving shaft of the engine 10 and the driving shaft of the electric motor 13, the clutch 12 enables the shaft of the engine 10 and the driving shaft of the electric motor 13 to rotate at each different rate. For example, at the time of having the electric motor 13 generate electric power with drive power of the engine 10, at the time when the engine 10 is assisted with drive power of the electric motor 13, and when the engine 10 gets started with the electric motor 13, and the like, the clutch 12 mechanically connects the driving shaft of the engine 10 and the driving shaft of the electric motor 13. On the other hand, for example, in the case where the hybrid vehicle 1 is driving by use of the drive power of the electric motor 13 while the engine 10 is in a halt condition or an idle state, or otherwise in the case where the hybrid vehicle 1 is slowing down or driving on a downhill and the electric motor 13 generates electric power (regenerating electric power) while the engine 10 is in a halt condition or an idle state, the clutch 12 disconnects the mechanical connection between the driving shaft of the engine 10 and the driving shaft of the electric motor 13. Incidentally, the clutch 12 is different from a clutch that a driver operates by way of using a clutch pedal.

The electric motor 13 is a so-called electric motor-generator. The electric motor 13 generates drive power for rotating a shaft by use of electric power supplied from the inverter 14, and supplies the shaft output to the transmission 16. On the other hand, the electric motor 13 generates electric power by use of drive power for rotating the shaft, the drive power being supplied from the transmission 16; and then the electric power is supplied to the inverter 14. For example, when the hybrid vehicle 1 is increasing speed or driving at a constant speed, the electric motor 13 generates the drive power for rotating the shaft, and supplies the shaft output to the transmission 16 to drive the hybrid vehicle 1 in cooperation with the engine 10. On the other hand, for example, when the electric motor 13 is driven by the engine 10, or the hybrid vehicle 1 is slowing down or driving on a downhill or in a similar situation, the motor 13 operates as an electric power generator. At the time of operating as an electric power generator, the electric motor 13 generates electric power by use of drive power for rotating the shaft, the drive power being supplied from the transmission 16; in order to supply the electric power to the inverter 14.

The inverter 14 is controlled by the electric motor ECU 17. The inverter 14 transforms direct-current voltage from the battery 15 into alternative-current voltage. Moreover, the inverter 14 transforms alternative-current voltage from the electric motor 13 into direct-current voltage. When the electric motor 13 generates drive power, the inverter 14 transforms direct-current voltage from the battery 15 into alternative-current voltage, and supplies the electric motor 13 with electric power. In the meantime, when the electric motor 13 generates electric power, the inverter 14 transforms alternative-current voltage from the electric motor 13 into direct-current voltage. Namely, in this case, the inverter 14 plays a role of a rectifier and a voltage regulating device, for supplying the battery 15 with direct-current voltage.

The battery 15 is a secondary battery that is chargeable and dischargeable. When the electric motor 13 generates drive power, the battery 15 supplies the electric motor 13 with electric power by the intermediary of the inverter 14. Moreover, when the electric motor 13 generates electric power, the battery 15 is charged with the electric power generated by the electric motor 13.

The transmission 16 has a semi-automatic transmission (not shown) that makes a choice among a plurality of gear ratios (transmission gear ratios), according to a gear-shift instruction signal coming from the hybrid ECU 18. While shifting the transmission gear ratio by use of the semi-automatic transmission, the transmission 16 transmits gear-shifted drive power of the engine 10 and drive power of the electric motor 13, to the wheel 20. Otherwise, while shifting the transmission gear ratio by use of the semi-automatic transmission, the transmission 16 transmits gear-shifted drive power of the engine 10 or drive power of the electric motor 13, to the wheel 20. Moreover, at the time of slowing down or driving on a downhill or in a similar situation, the transmission 16 transmits drive power from the wheel 20 to the electric motor 13. Incidentally, a gear position can manually be shifted to an optional gear in the semi-automatic transmission if a driver operates a shift unit 23.

The electric motor ECU 17 is a computer that cooperates with the engine ECU 11 according to control by the hybrid ECU 18. The electric motor ECU 17 controls the electric motor 13 by way of controlling the inverter 14. For example, the electric motor ECU 17 is structured with a CPU, an ASIC, a microprocessor, or a DSP; and it internally includes an arithmetic section, a memory, an I/O (input/output) port, and so on.

The hybrid ECU 18 is an example of a computer. The hybrid ECU 18 obtains various information necessary for hybrid driving (such as, information on accelerator position, information on braking operation, information on vehicle speed, information on gear position, information on engine revolution rate, charging condition, and the like). On the basis of such information obtained; the hybrid ECU 18 controls the clutch 12, also controls the transmission 16 by way of supplying a gear-shift instruction signal, provides the electric motor ECU 17 with a control instruction on the electric motor 13 and the inverter 14, and provides the engine ECU 11 with a control instruction on the engine 10. Moreover, by the intermediary of the electric motor ECU 17, the hybrid ECU 18 obtains temperature information of the inverter 14 and current value information to be input into the inverter 14, and then detects abnormality of the temperature sensor 19 on the basis of the information obtained. Incidentally, details of this process (hereinafter, called 'abnormality detection process') are described later. The hybrid ECU 18 is structured with a CPU, an ASIC, a microprocessor, or a DSP; and it internally includes an arithmetic section, a memory, an I/O (input/output) port, and so on.

Incidentally, being saved beforehand in a non-volatile memory placed inside the hybrid ECU 18, a program to be executed by the hybrid ECU 18 can be installed in advance in the hybrid ECU 18 as a computer.

The engine ECU 11, the electric motor ECU 17, and the hybrid ECU 18 are connected one another, through a bus that is in conformity with a standard specification such as CAN (Control Area Network).

The temperature sensor 19 is a sensor for measuring a temperature of a main circuit element (for example, IGBT: Insulated Gate Bipolar Transistor) and the like, which configures the inverter 14. An output of detection coming from the temperature sensor 19 is loaded into the hybrid ECU 18, by the intermediary of the electric motor ECU 17. Incidentally, a configuration may be implemented in such a way that an output of detection from the temperature sensor 19 is loaded directly into the hybrid ECU 18. The temperature sensor 19 is constructed with a thermo-sensor such as; for example, a thermocouple, a thermistor, a thermostatic diode (diode thermometer).

The wheel 20 is a driving wheel that transmits driving power to a roadway surface. Incidentally, though only one wheel 20 is illustrated in FIG. 1, the hybrid vehicle 1 actually has a plurality of wheels 20.

FIG. 2 is a block diagram showing an example of functional configuration of the hybrid ECU 18 represented in FIG. 1, for implementation of an abnormality detection process. When the hybrid ECU 18 executes a predetermined program, implemented are functions of an information obtainment unit 31, a heat amount estimation unit 32 (a heat amount calculation means described in the claims), a temperature deviation calculation unit 33 (a temperature change calculation means described in the claims), a coordinate value calculation unit 34 (a coordinate value calculation means described in a claim), and an abnormality detection unit 35 (an abnormality detection means described in the claims). Incidentally, abnormality judgment area data 36, to which the abnormality detection unit 35 refers, is stored in the non-volatile memory placed inside the hybrid ECU 18.

The information obtainment unit 31 obtains information necessary for judging abnormality of the temperature sensor 19. Concretely to describe, the information obtainment unit 31 obtains; information that shows a transition of a current value in a predetermined time period with the current being input into the inverter 14 in a predetermined time period, time-wise (energization time) information with a current input into the inverter 14 in a predetermined time period, and temperature information of the temperature sensor 19 in a predetermined time period. The predetermined time period in this context means a period of, for example, 10 seconds, 20 seconds, and the like. Out of the obtained information, the information obtainment unit 31 outputs current value information (A) in the predetermined time period, and energization time information (S) in the predetermined time period, to the heat amount estimation unit 32. In the meantime, the information obtainment unit 31 outputs information (Te) that shows a transition of a temperature sensed by the temperature sensor 19 in the predetermined time period, to the temperature deviation calculation unit 33.

The heat amount estimation unit 32 estimates the amount of heat flowing into the inverter 14. The heat amount estimation unit 32 calculates the amount of heat generated from the inverter 14 on the basis of the current value information (A) in the predetermined time period and the energization time information (S) in the predetermined time period, both the pieces of information being output from the information obtainment unit 31. The amount of heat is calculated, for example, as an hour integration value by integrating the square of current value and the energization time. Incidentally, the current value may be the cube instead. The heat amount estimation unit 32 outputs the hour integration value information (Y{A2×S}) that has been calculated, to the coordinate value calculation unit 33.

The temperature deviation calculation unit 33 calculates a deviation of the temperature in the predetermined time period for assessing a temperature change of the inverter 14, the temperature being sensed by the temperature sensor 19. The temperature deviation calculation unit 33 identifies a maximum temperature (Max) and a minimum temperature (Min) that the temperature sensor 19 has sensed in the predetermined time period, on the basis of the temperature information (T) output by the information obtainment unit 31, and calculates an absolute value of a difference between these temperature values as temperature deviation information (ΔT|Max - Min|). Then, the deviation calculation unit 33 outputs the temperature deviation information (ΔT|Max - Min|) that has been calculated, to the coordinate value calculation unit 34.

The coordinate value calculation unit 34 calculates a coordinate value, in the case of having the hour integration value (Y) on an X-axis and the temperature deviation (AT) on a Y-axis. The coordinate value calculation unit 34 calculates a coordinate value (Xn, Ym) on the basis of the hour integration value information (Y{A2×S}) output by the heat amount estimation unit 32, and the temperature deviation information (ΔT|Max - Min|) output by the deviation calculation unit 33. Then, the coordinate value calculation unit 34 outputs the coordinate value (Xn, Ym) that has been calculated, to the abnormality detection unit 35.

The abnormality detection unit 35 records the coordinate value (Xn, Ym) output by the coordinate value calculation unit 34, in a memory; and if the coordinate value (Xn, Ym) is continuously included within the abnormality judgment area data 36 for a certain time, the abnormality detection unit 35 detects abnormality of the temperature sensor 19. In the case of having detected abnormality of the temperature sensor 19, the abnormality detection unit 35 outputs an abnormality detection signal SG. In the case of having detected abnormality, the hybrid vehicle 1, for example, turns on a dedicated LED lamp and the like, or otherwise alarms a sound and so on in order to notify a driver of the abnormality of the temperature sensor 19.

### [Operation]

FIG. 3 is a flowchart showing an abnormality detection process on temperature sensor 19, which is executed by the hybrid ECU 18 represented in FIG. 1. Incidentally, steps from 'START' to 'END' in the flowchart of FIG. 3 represent processing of one cycle. Even though the processing reaches 'END', the processing starts again if conditions for 'START' are fulfilled.

START: For example, if once a drive key is operated and the hybrid ECU 18 gets started, the hybrid ECU 18 executes the predetermined program. Then, if the functions shown in FIG. 2 become ready for practice, operation progresses to Step S1.

Step S1: The information obtainment unit 31 of the hybrid ECU 18 obtains the transition of the temperature of the main circuit element, configuring the inverter 14, in the predetermined time period, on the basis of the temperature information notified from the temperature sensor 19; and also obtains the transition of the current value in the predetermined time period, with the current being input into the inverter 14. After obtaining the temperature of the main circuit element, configuring the inverter 14, and also the current value, with the current being input into the inverter 14, in the predetermined time period, the hybrid ECU 18 shifts its operation to Step S2.

Step S2: The heat amount estimation unit 32 of the hybrid ECU 18 estimates the amount of heat to be input into the inverter 14, on the basis of the current value and the energization time, obtained at Step S1. The amount of heat to be input into the inverter 14 can be obtained by way of calculating the hour integration value information (Y{A2×S}) described above.

Step S3: The temperature deviation calculation unit 33 of the hybrid ECU 18 calculates the amount of temperature change of the inverter 14, obtained at Step S1. The amount of temperature change can be calculated by way of calculating the temperature deviation information (ΔT|Max - Min|) described above. Incidentally, Step S2 and Step S3 may be executed in reversed order, or these steps may be executed in parallel.

Step S4: The coordinate value calculation unit 34 of the hybrid ECU 18 records the coordinate value (Xn, Ym) in a coordinate system, into an internal memory; the coordinate system being represented by way of having the hour integration value information (Y{A2×S}), calculated at Step S2, on an X-axis and the temperature deviation information (ΔT|Max - Min|), calculated at Step S3, on a Y-axis.

Step S5: The abnormality detection unit 35 of the hybrid ECU 18 makes a judgment on whether or not the coordinate value (Xn, Ym) is continuously included within the abnormality judgment area data 36 for a certain time; the coordinate value (Xn, Ym) having been recorded into the internal memory at Step S4.

Step S6: In the case of having judged at Step S5 that it is included (YES at Step S5), the abnormality detection unit 35 of the hybrid ECU 18 turns on a dedicated LED lamp and the like, for notifying of abnormality of the temperature sensor 19, with an output of the abnormality detection signal SG; or otherwise informing a driver of the hybrid vehicle 1 of the same by use of a sound, so that the abnormality detection process finishes (END). Incidentally, even in the case where the drive key is so operated as to stop the hybrid ECU 18, the abnormality detection process finishes (END).

Step S7: In the case of having judged at Step S5 that it is not included (NO at Step S5), the abnormality detection unit 35 of the hybrid ECU 18 makes a judgment that the temperature sensor 19 has no abnormality and then the abnormality detection process finishes (END).

FIG. 4 is an example of a diagram in which an X-axis represents time (TIME) of energizing the main circuit element of the inverter 14 shown in FIG. 1, and meanwhile a Y-axis represents the square of a current value of a current (A2), the current flowing into the main circuit element of the inverter 14. The amount of heat energy flowing into the main circuit element of the inverter 14 for a predetermined time period T1 corresponds to an area of a shaded section 'S' shown in FIG. 4.

FIG. 5 is an example of a diagram represented by way of having an X-axis with hour integration value information (Y{A2×S}) and a Y-axis with temperature deviation information (ΔT|Max - Min|). In FIG. 5, a normal operation pattern area 'A' shows a coordinate area represented by connecting outer circumferential dots of a plurality of coordinate values obtained through experiments of a variety of driving patterns with the hybrid vehicle 1. On the other hand, abnormality judgment areas 'B' and 'C' shown in FIG. 5 are areas outside the normal operation pattern area 'A'. If the coordinate value is continuously included in either of those areas for a certain time, it means that the abnormality detection unit 35 of the hybrid ECU 18 detects abnormality of the temperature sensor 19.

In the case where the coordinate value calculated by the coordinate value calculation unit 34 of the hybrid ECU 18 is included in the abnormality judgment area 'B' shown in FIG. 5, it means that a large change in temperature is observed, in comparison with a temperature change under normal conditions. Namely, in this case, even though the current flows less through the inverter 14 so that only a less amount of energy (heat amount) flows into the main circuit element of the inverter 14, a large change is observed in the temperature sensed by the temperature sensor 19, in comparison with a temperature change under normal conditions.

FIG. 6 is a diagram that shows an example of a change in temperature included in the abnormality judgment area 'B' shown in FIG. 5. In FIG. 6, an X-axis represents time (Time) of energizing the main circuit element of the inverter 14 shown in FIG. 1, and meanwhile a Y-axis represents a change in temperature (deg C) of the main circuit element of the inverter 14, the change in temperature being sensed by the temperature sensor 19.

'T1' shown in FIG. 6 is the same predetermined time period as 'T1' in FIG. 4. 'Te2' shown in FIG. 6 is a threshold for abnormality judgment. The threshold for abnormality judgment corresponds to the abnormality judgment area 'B' shown in FIG. 5. The threshold for abnormality judgment is determined according to a coordinate area represented by connecting outer circumferential dots of a plurality of coordinate values obtained through experiments of a variety of driving patterns, under conditions where the temperature sensor 19 works normally. 'Te3' shown in FIG. 6 is a difference between a minimum temperature (Min) and a maximum temperature (Max) with respect to a temperature of the main circuit element of the inverter 14, sensed by the temperature sensor 19 in the predetermined time period 'T1'. In an example that FIG. 6 shows, it is observed that a change in temperature exceeds an area range of 'Te2'. Therefore, if the behavior shown in FIG. 6 is continuously observed for a certain time, it means that a coordinate value is included in the abnormality judgment area 'B' shown in FIG. 5. As a result, the abnormality detection unit 35 of the hybrid ECU 18 detects abnormality of the temperature sensor 19.

With FIG. 5 being referred to again; in the case where the coordinate value calculated by the hybrid ECU 18 is included in the abnormality judgment area 'C', it means that a small change in temperature is observed, in comparison with a temperature change under normal conditions. Namely, in this case, even though the energy flows more through the main circuit element of the inverter 14, a small change is observed in the temperature sensed by the temperature sensor 19, in comparison with a temperature change under normal conditions.

FIG. 7 is a diagram that shows an example of a change in temperature included in the abnormality judgment area 'C' shown in FIG. 5. In FIG. 7, an X-axis represents time (Time) of energizing the main circuit element of the inverter 14 shown in FIG. 1, and meanwhile a Y-axis represents a change in temperature (deg C) of the main circuit element of the inverter 14, the change in temperature being sensed by the temperature sensor 19.

'T1' shown in FIG. 7 is the same predetermined time period as 'T1' in FIG. 4. 'Te4' shown in FIG. 7 is a threshold for abnormality judgment. The threshold for abnormality judgment corresponds to the abnormality judgment area 'C' shown in FIG. 5. The threshold for abnormality judgment is determined according to a coordinate area represented by connecting outer circumferential dots of a plurality of coordinate values obtained through experiments of a variety of driving patterns, under conditions where the temperature sensor 19 works normally. 'Te5' shown in FIG. 7 is a difference between a minimum temperature (Min) and a maximum temperature (Max) with respect to a temperature of the main circuit element of the inverter 14, sensed by the temperature sensor 19 in the predetermined time period 'T1'. In an example that FIG. 7 shows, it is continuously observed for a certain time that a change in temperature does not exceed an area range of 'Te4.' In this case, a coordinate value is included in the abnormality judgment area 'C' shown in FIG. 5 so that the abnormality detection unit 35 of the hybrid ECU 18 detects abnormality of the temperature sensor 19.

### [Advantageous effect]

As described above, the hybrid ECU 18 as an example of an abnormality detection apparatus for detecting abnormality of the temperature sensor 19 includes: the heat amount calculation unit 32 (a heat amount calculation means) which calculates the amount of heat generated in the predetermined time period from the main circuit element of the inverter 14 as an object of sensing temperature by the temperature sensor 19; the temperature deviation calculation unit 33 (a temperature change calculation means) which calculates the amount of temperature change of the main circuit element of the inverter 14 in the predetermined time period; the coordinate value calculation unit 34 (a coordinate value calculation means) which calculates the coordinate value in the coordinate system represented by having the heat amount information calculated by the heat amount calculation unit 32 on a coordinate axis and having the temperature deviation information (ΔT|Max - Min|, information on the amount of temperature change) of the temperature sensor 19, calculated by the temperature deviation calculation unit 33, on another coordinate axis; and the abnormality detection unit 35 (an abnormality detection means) which detects abnormality of the temperature sensor 19 in the case where the coordinate value calculated by the coordinate value calculation unit 34 is included in either of the abnormality judgment areas 'B' and 'C' (the predetermined abnormality detection judgment areas) in the coordinate system continuously for a certain time. According to this arrangement, abnormality is detected in the case where an abnormal change in temperature is observed continuously for a certain time, and therefore it is possible to cut down a detection error and appropriately detect abnormality of the temperature sensor 19.

Moreover, the abnormality judgment area 'B' or 'C' is a coordinate area not included in the normal operation pattern area 'A' formed with a plurality of coordinate values obtained on the basis of relationships between the hour integration value information (Y{A2×S}) (an hour integration value), calculated by use of the current value and the energization time of the main circuit element of the inverter 14 in the predetermined time period, and the temperature deviation information (ΔT|Max - Min|) (the amount of temperature change) of the main circuit element of the inverter 14 in the predetermined time period, under conditions where the temperature sensor 19 works normally. Then, in the case where the coordinate value calculated by the coordinate value calculation unit 34 is continuously included for a certain time in the abnormality judgment area 'B' (a first abnormal temperature-change area), in which the amount of temperature change calculated by the temperature deviation calculation unit 33 is greater, in comparison with the coordinate values included in the normal operation pattern area 'A', or the coordinate value calculated by the coordinate value calculation unit 34 is continuously included for a certain time in the abnormality judgment area 'C' (a second abnormal temperature-change area), in which the amount of temperature change calculated by the temperature deviation calculation unit 33 is smaller, in comparison with the coordinate values included in the normal operation pattern area 'A', the abnormality detection unit 35 detects abnormality of the temperature sensor 19. According to this arrangement, in the case where the change in temperature sensed by the temperature sensor 19 is significantly large in comparison with a temperature change under normal conditions even though only a less amount of energy (heat amount) flows into the main circuit element of the inverter 14, or the change in temperature sensed by the temperature sensor 19 is significantly small in comparison with a temperature change under normal conditions even though a large amount of energy (heat amount) flows into the main circuit element of the inverter 14, abnormality of the temperature sensor 19 can be detected. In other words, since abnormality of the temperature sensor 19 is detected by way of making a comparison with a behavior pattern in operation under normal conditions, the abnormality of the temperature sensor 19 can be detected more appropriately. Incidentally, although two of the abnormality judgment area 'B' and the abnormality judgment area 'C' are used in the abnormality detection process explained with reference to FIG. 3, alternatively the abnormality detection process may be carried out by using only one of the abnormality judgment areas. Incidentally, if a use of a thermistor as the temperature sensor 19 restricts a range of accurate detection so that the same behavior may be observed outside the range, under normal conditions as well as abnormal conditions. In such a case, a use of a thermostatic diode (diode thermometer) further reduces a risk of a detection error in comparison with the case of using a thermistor.

Furthermore, the hybrid vehicle 1 having the hybrid ECU 18 described above, an abnormality detection method to be executed by the hybrid ECU 18, and various programs for operating a computer as the hybrid ECU 18 produce the same effects as each effect described above.

### [Preferred embodiments using a program]

Moreover, the hybrid ECU 18 may be configured with a general-purpose information processing unit to be operated by a predetermined program. For example, such a general-purpose information processing unit has a memory, a CPU, an I/O port and the like. The CPU of the general-purpose information processing unit loads a control program as a predetermined program, from the memory and the like, and then executes the control program. Thus, a function of the hybrid ECU 18 is materialized in the general-purpose information processing unit. Furthermore, another function can also be materialized by use of a general-purpose information processing unit and a program, as far as the function can be materialized with software. Incidentally, instead of the CPU described above, an ASIC, a microprocessor, a DSP and the like may also be used.

Incidentally, the control program to be executed by the general-purpose information processing unit may be a program stored in a memory and the like of the general-purpose information processing unit before a delivery of the hybrid ECU 18, or may be a program stored in the memory and the like of the general-purpose information processing unit after the delivery of the hybrid ECU 18. Moreover, alternatively a part of the control program may be stored in the memory and the like of the general-purpose information processing unit after the delivery of the hybrid ECU 18. The control program to be stored in the memory and the like of the general-purpose information processing unit, after the delivery of the hybrid ECU 18, may be a program installed, having been stored in a computer-readable record medium such as a CD-ROM; or may be a program installed, having been downloaded by the intermediary of a transmission medium such as the Internet.

Moreover, the control program includes not only a program that can directly be executed by the general-purpose information processing unit, but also a program that becomes ready for execution at the time of being installed in a hard disc and so on. Furthermore, the control program also includes a program that is compressed or encrypted.

If the function of the hybrid ECU 18 is materialized with the general-purpose information processing unit and the program in this way, it becomes possible to flexibly deal with mass production as well as a specification change (or a design change).

### [Other embodiments]

The embodiment of the present invention can be modified in various ways without departing from the concept of the present invention. For example, although the temperature sensor 19 is illustrated in the inverter 14, the illustration does not limit an installation position to an internal part of the inverter 14. For example, the temperature sensor 19 may be placed at an external part of the inverter 14 in order to measure a temperature of a chassis of the inverter 14 for indirectly estimating a temperature of the inverter 14. Otherwise, the temperature sensor 19 may measure a temperature of a surrounding atmosphere of the installation position of the inverter 14 so that the temperature of the inverter 14 can indirectly be estimated by way of measuring the temperature of a surrounding atmosphere of the installation position of the inverter 14. Moreover, a camera unit may be installed instead of the temperature sensor 19 in order to externally measure a temperature of the chassis of the inverter 14 so that an image analysis method such as thermography is applied.

Moreover, although the abnormality detection is carried out for the temperature sensor 19 of the inverter 14, the abnormality detection can be applied to a temperature sensor installed for any unit other than the inverter 14. For example, alternatively the same can be applied to abnormality detection for a temperature sensor (not shown) for detecting a temperature of an element included in the electric motor 13.

Incidentally, in the case where the electric motor 13 is an object of sensing temperature by the temperature sensor 19, the temperature may be estimated according to a value of a current input into the electric motor 13; or alternatively the amount of heat generated from the electric motor 13 may be estimated according to a mechanical output that is calculated by way of multiplying the product of the number of revolutions and torque of the electric motor 13 by a predetermined coefficient.

Moreover, although the engine 10 is explained as an internal combustion engine, it may also be any one of other thermal engines including an external combustion engine.

Furthermore, each ECU (the engine ECU 11, the electric motor ECU 17, and the hybrid ECU 18) may be materialized as an integrated ECU including all these functions, or otherwise another ECU created by further dividing the function of each ECU may be newly provided. Moreover, the function to be materialized in the hybrid ECU 18, shown in FIG. 2, may be materialized in the electric motor ECU 17.

Moreover, although the hybrid vehicle 1 is described as a machine of a parallel method, alternatively it may be a machine of a series method in which an engine is used for generating electricity and a motor is used for only driving a wheel axis and regeneration, or it may be a machine of a split method in which a drive power from the engine is divided by a power dividing mechanism using a planetary gear and the like, in order to distribute the power to a power generator and the motor.

Moreover, the program to be executed by the computer may be a program in which operation steps are chronologically executed in order as explained in this specification document; or it may be another program in which operation steps are executed in parallel, or executed at a time required, such as at the time of a call invoked.

### {Reference Signs List}

1. hybrid vehicle, 10. engine, 13. electric motor, 15. battery, 18. hybrid ECU (an example of an abnormality detection apparatus), 19. temperature sensor, 32. heat amount calculating unit (an example of a heat amount calculation means), 33. temperature deviation calculation unit (an example of a temperature change calculation means), 34. coordinate value calculation unit (an example of a coordinate value calculation means), 35. abnormality detection unit (an example of an abnormality detection means)

## Claims

1. An abnormality detection apparatus for detecting abnormality of a temperature sensor, comprising:
a heat amount calculation means which calculates the amount of heat generated in a predetermined time period from an object of sensing temperature by the temperature sensor;
a temperature change calculation means which calculates the amount of temperature change of the object of sensing temperature in the predetermined time period;
a coordinate value calculation means which calculates a coordinate value in a coordinate system represented by having the heat amount information calculated by the heat amount calculation means, on a coordinate axis, and having information on the amount of temperature change of the temperature sensor, calculated by the temperature change calculation means, on another coordinate axis; and
an abnormality detection means which detects abnormality of the temperature sensor in the case where the coordinate value calculated by the coordinate value calculation means is included in a predetermined abnormality detection judgment area in the coordinate system continuously for a certain time.

2. The abnormality detection apparatus according to claim 1;
wherein, the predetermined abnormality detection judgment area is a coordinate area not included in a normal operation pattern area formed with a plurality of coordinate values obtained on the basis of relationships between an hour integration value calculated by use of a current value and an energization time of the object of sensing temperature in a predetermined time period, and the amount of temperature change of the object of sensing temperature in the predetermined time period, under conditions where the temperature sensor works normally;
in the case where the coordinate value calculated by the coordinate value calculation means is continuously included for a certain time in a first abnormal temperature-change area, in which the amount of temperature change calculated by the temperature change calculation means is greater, in comparison with the coordinate values included in the normal operation pattern area, or
in the case where the coordinate value calculated by the coordinate value calculation means is continuously included for a certain time in a second abnormal temperature-change area, in which the amount of temperature change calculated by the temperature change calculation means is smaller, in comparison with the coordinate values included in the normal operation pattern area;
under either of the conditions described above, the abnormality detection means detects abnormality of the temperature sensor.

3. A hybrid vehicle comprising:
a temperature sensor,
a heat amount calculation means which calculates the amount of heat generated in a predetermined time period from an object of sensing temperature by the temperature sensor;
a temperature change calculation means which calculates the amount of temperature change of the object of sensing temperature in the predetermined time period;
a coordinate value calculation means which calculates a coordinate value in a coordinate system represented by having the heat amount information calculated by the heat amount calculation means, on a coordinate axis, and having information on the amount of temperature change of the temperature sensor, calculated by the temperature change calculation means, on another coordinate axis; and
an abnormality detection means which detects abnormality of the temperature sensor in the case where the coordinate value calculated by the coordinate value calculation means is included in a predetermined abnormality detection judgment area in the coordinate system continuously for a certain time.

4. An abnormality detection method for detecting abnormality of a temperature sensor, comprising:
a heat amount calculation step of calculating the amount of heat generated in a predetermined time period from an object of sensing temperature by the temperature sensor;
a temperature change calculation step of calculating the amount of temperature change of the object of sensing temperature in the predetermined time period;
a coordinate value calculation step of calculating a coordinate value in a coordinate system represented by having the heat amount information calculated by the heat amount calculation step, on a coordinate axis, and having information on the amount of temperature change of the temperature sensor, calculated by the temperature change calculation step, on another coordinate axis; and
an abnormality detection step of detecting abnormality of the temperature sensor in the case where the coordinate value calculated by the coordinate value calculation step is included in a predetermined abnormality detection judgment area in the coordinate system continuously for a certain time.

5. A computer program causing a computer to function for detecting abnormality of a temperature sensor as:
a heat amount calculation means which calculates the amount of heat generated in a predetermined time period from an object of sensing temperature by the temperature sensor;
a temperature change calculation means which calculates the amount of temperature change of the object of sensing temperature in the predetermined time period;
a coordinate value calculation means which calculates a coordinate value in a coordinate system represented by having the heat amount information calculated by the heat amount calculation means, on a coordinate axis, and having information on the amount of temperature change of the temperature sensor, calculated by the temperature change calculation means, on another coordinate axis; and
an abnormality detection means which detectes abnormality of the temperature sensor in the case where the coordinate value calculated by the coordinate value calculation means is included in a predetermined abnormality detection judgment area in the coordinate system continuously for a certain time.
